# EUROPÄISCHE PATENTANMELDUNG

(11) **EP 1 156 564 A1**
(43) Veröffentlichungstag der Anmeldung: **21.11.2001**
(21) Anmeldenummer: 01111405.5
(22) Anmeldetag: 10.05.2001
(51) Int. Cl.: H02B 1/044, H05K 5/00

(54) **Gehäuse für einen Schalter**

(30) Priorität: 18.05.2000 DE 20008968 U
(71) Anmelder: Mannesmann VDO Aktiengesellschaft, 60388 Frankfurt am Main (DE)
(72) Erfinder: Dörrie, Christian,Dipl.-Ing.(FH), 76139 Karlsruhe (DE)

(57) **Zusammenfassung**

Das Gehäuse, das einen auf einer Leiterplatte angeordneten Drehschalter aufnehmen soll, ist mit einem Gewindeansatz versehen, mittels dessen es an einer Wand befestigt werden kann, durch die eine dem Drehschalter zugeordnete Stellwelle hindurchgreift. Das Gehäuse ist derart zweiteilig ausgebildet, dass an jedem Gehäusebauteil (9, 10) eine Hälfte (19, 20) des Gewindeansatzes angeformt ist. Das Zusammenfügen der beiden Gehäusebauteile (9, 10) erfolgt mittels Rastverbindungsmittel (11, 12, 13, 14) sowie in Ösen eingreifende Haken von denen einer mit 16 bezeichnet ist.

## Beschreibung

Die Erfindung betrifft ein Gehäuse für ein Eingabeaggregat mit einem Drehschalter, welcher auf einer Leiterplatte angeordnet ist, mit einer dem Drehschalter zugeordneten Stellwelle und mit einem auf der Leiterplatte befestigten Steckersockel sowie mit Mitteln zum Befestigen des Eingabeaggregates an einer Wand, wobei die Stellwelle durch die Wand hindurchgreift.

An sich bekannte Eingabeaggregate der oben genannten Art sind mit einem Gewinde versehen, mittels dessen sie beispielsweise an einer Frontwand eines Gerätegehäuses befestigt werden können derart, dass die Stellwelle, welcher in der Regel ein Einstellknopf zugeordnet ist durch die Frontwand nach außen durchgreift. In solchen Fällen, das heißt im Falle eines geschlossenen Gerätes, ist das eingebaute Eingabeaggregat durch das Gerätegehäuse vor Zugriffen und gegen Verschmutzungen geschützt und benötigt kein eigenes Gehäuse. Eine Anordnung des Eingabeaggregates unmittelbar an einer Trennwand, beispielsweise an einem Armaturenbrett eines Kraftfahrzeuges, wo der rückseitige Zugang für Kontroll- und Instandsetzungsmaßnahmen zugänglich sein muss, macht es erforderlich, dass dem Eingabeaggregat ein schützendes Gehäuse zugeordnet wird. Außerdem ist es bei dieser Anwendung notwendig eine milieugerechte Befestigung vorzusehen. Das heißt, es müssen zusätzliche Maßnahmen getroffen werden, um ein an sich funktionsfertiges Eingabeaggregat unabhängig von mit Gehäusen versehenen Geräten oder Instrumententrägem im Kraftfahrzeug einbauen zu können.

Aufgabe der vorliegenden Erfindung ist es daher, ein gattungsgemäßes Eingabeaggregat mit möglichst geringem Fertigungs- und Montageaufwand berührungs- und verschmutzungssicher einzuhausen, derart, dass die Stellwelle und der Steckersockel zugänglich bleiben und eine problemlose Montage des Eingabeaggregates am Einbauort sowie eine zuverlässige Befestigung gewährleistet ist.

Die Lösung der Aufgabe ist dadurch gekennzeichnet, dass das Gehäuse Mittel zur Halterung des Eingabeaggregates aufweist, dass an dem Gehäuse ein Gewindeansatz ausgebildet ist und dass die Befestigung des Eingabeaggregates mittelbar durch Verschrauben des Gehäuses mit der Wand erfolgt.

Eine bevorzugte Ausführungsform des Gehäuses sieht vor, dass das Gehäuse zweiteilig derart ausgebildet ist, dass an jedem Gehäusebauteil eine Hälfte des Gewindeansatzes angeformt ist.

Das bevorzugte Ausführungsbeispiel zeichnet sich ferner dadurch aus, dass an den den Gewindeansatzhälften abgewandten Wänden der Gehäusebauteile Mittel für wenigstens eine Renkverbindung, an den mit den Gewindeansatzhälften versehenen Wänden Mittel für wenigstens eine Rastverbindung angeformt sind, dass die Gewindeansatzhälften als der Stellwelle zugeordnete Lagerschalen ausgebildet sind und dass an den Gehäusebauteilen als Fassung für die Leiterplatte dienende Rippenelemente sowie Schlitze vorgesehen sind.

Die Erfindung bietet mit der geteilten Ausbildung des Gewindeansatzes den Vorzug, dass lediglich zwei werkzeuglos zusammenfügbare, relativ grob tolerierte Gehäusehälften hergestellt werden müssen, welche erst beim Befestigen des Eingabeaggregates an einer Wand miteinander fest verbunden werden. Dabei sind die Rastverbindungsmittel an der Flanschseite, die Renkverbindungsmittel an der der Flanschseite entgegengesetzten Seite des Gehäuses ausgebildet, was einen beschädigungsfreien Eingriff in das Gehäuse, wenn es an der Wand befestigt ist, verhindert. An dieser Stelle sei noch erwähnt, dass an Stelle der Renkverbindungsmittel auch ein Filmscharnier ausbildbar ist mit dem Vorzug, dass bei der Montage des Gehäuses Verwechslungen von Gehäusebauteilen oder Lagekorrekturen vermieden sind. Ein weiterer Vorteil der erfindungsgemäßen Ausbildung ist darin zu sehen, dass der Gewindeansatz des Gehäuses spritzgießtechnisch hergestellt werden kann und somit keinen zusätzlichen Aufwand bedingt. Ferner bietet die erfindungsgemäße Einhausung dem Eingabeaggregat einen ausreichenden Staubschutz, insbesondere aber einen sicheren Griffschutz bei dessen Handhabung während der Montage.

Vorteilhaft ist außerdem, dass das Eingabeaggregat mittelbar durch Befestigen des Gehäuses, in welchem es in zweckmäßiger Weise gehaltert ist, befestigt wird. Das heißt, an dem Gehäuse kann ein Gewindeansatz ausgebildet werden, der im Hinblick auf die Befestigungssicherheit optimale Anflanschbedingungen bietet.

Im folgenden sei die Erfindung anhand von Zeichnungen näher erläutert. Es zeigen:
- Figur 1: eine Übersichtsdarstellung, und zwar eine Seitenansicht des Gehäuses mit eingesetztem Eingabeaggregat,
- Figur 2: eine Draufsicht auf ein erstes Gehäusebauteil,
- Figur 3: eine Draufsicht auf ein zweites Gehäusebauteil,
- Figur 4: eine Innenansicht des ersten Gehäusebauteils gemäß der Projektionsrichtung X in Figur 2,
- Figur 5: eine Schnittdarstellung gemäß der Schnittlinie A in Figur 4,
- Figur 6: eine Schnittdarstellung gemäß der Schnittlinie B in Figur 4,
- Figur 7: eine Innenansicht des zweiten Gehäusebauteils gemäß der Projektionsrichtung Y in Figur 3,
- Figur 8: eine Schnittdarstellung gemäß der Schnittlinie C in Figur 7.

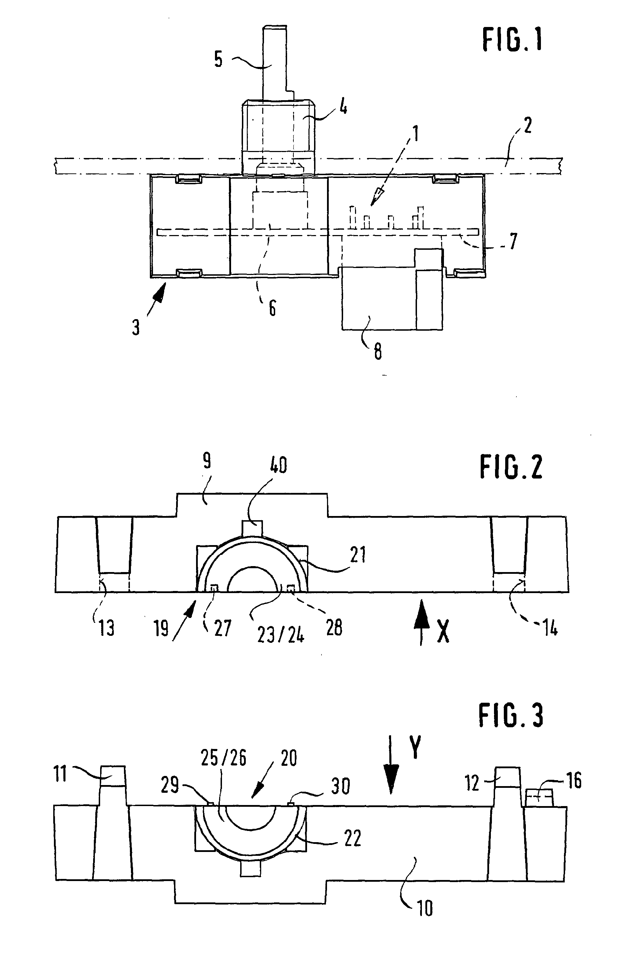

Die Übersichtsdarstellung, Figur 1, zeigt das eingehauste Eingabeaggregat 1 in Zuordnung zu einer Wand 2. Mittel zur Befestigung des Eingabeaggregates 1 an der Wand 2, die einem an dem Gehäuse 3 angeformten Gewindeansatz 4 zugeordnet sind, nämlich eine Zwischenlegscheibe und eine Mutter sind - weil nicht erfindungswesentlich - nicht dargestellt. Gleiches gilt für einen mit einer teilweise D-profilierten Stellwelle 5 des Eingabeaggregats 1 zu verbindenden Betätigungsknopf.

Der Vollständigkeit halber sei noch erwähnt, dass die Stellwelle 5 einem Drehschalter oder einem dreh- und axialbetätigbaren Schalter 6 zugeordnet ist, wobei die Stellwelle 5 beispielsweise auch als koaxiale Welle ausgebildet sein kann. Der Drehschalter 6 ist auf einer Leiterplatte 7 angeordnet, die einen Steckersockel 8 sowie wenigstens Mittel zur Spannungsversorgung und Signalaufbereitung trägt.

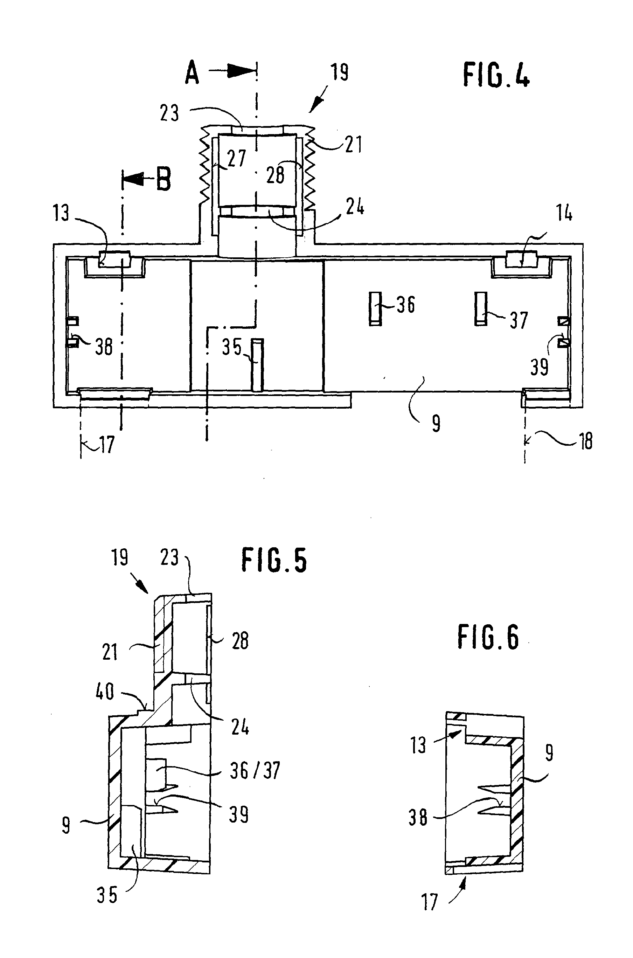

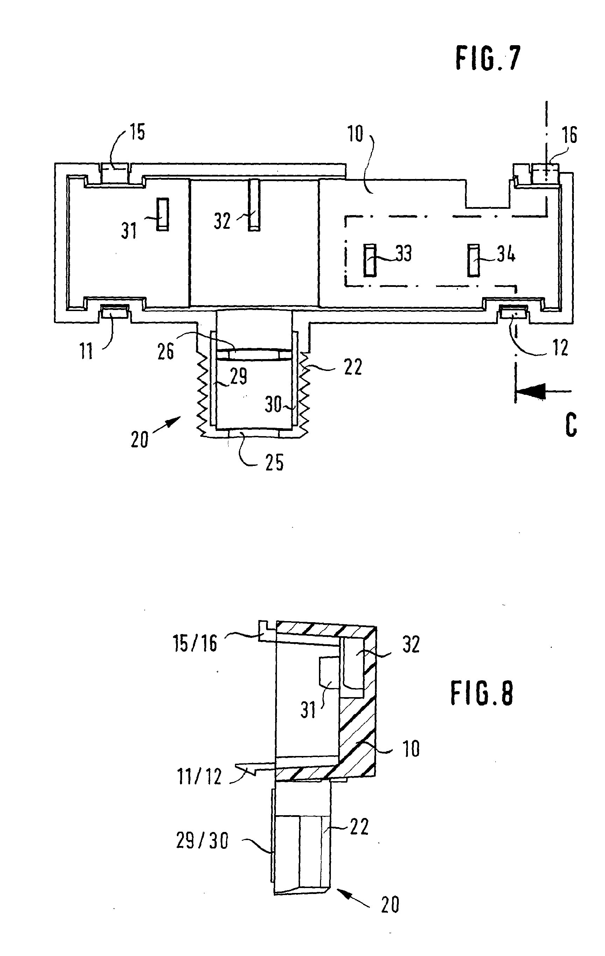

Die Figuren 2 und 3 zeigen die beiden Gehäusebauteile 9 und 10 des Gehäuses 3 in einer der Montage entsprechenden Zuordnung zueinander. Dabei werden beim Zusammenfügen der Gehäusebauteile 9 und 10 zunächst Renkverbindungsmittel und nachfolgend Rastverbindungsmittel in Eingriff gebracht. Als Rastverbindungsmittel sind am Gehäusebauteil 10 Klinken 11 und 12 angeformt, am Gehäusebauteil 9 sind Durchbrüche 13 und 14 ausgebildet. Von den Renkverbindungsmitteln sind in Figur 7 Haken 15 und 16 dargestellt. Die Figur 4 zeigt den Haken 15 und 16 zugeordnete, gießtechnisch freigesparte Ösen 17 und 18.

Wie ferner aus den Figuren 2 und 3 ersichtlich ist, sind, was ein wesentliches Merkmal der Erfindung darstellt, an jedem Gehäusebauteil 9, 10 Gewindeansatzhälften 19 und 20 angeformt, und zwar derart, dass die jeweiligen Teilgewinde 21 und 22 um eine halbe Steigung zueinander versetzt ausgebildet sind. Außerdem sind innerhalb der aus spritzgießtechnischen Gründen relativ dünnwandig ausgeformten Gewindeansatzhälften 19, 20 jeweils zwei Ringsegmente 23, 24 und 25, 26 ausgeformt, die nach dem zusammenfügen der Gehäusebauteile 9, 10 eine Lagerung für die Stellwelle 5 bilden. Mit 27 und 28 sind im Gehäusebauteil 9 angebrachte Vertiefungen bezeichnet. Diesen entsprechen Leisten 29 und 30, welche an dem Gehäusebauteil 10 angeformt sind. Diese Fügeelemente ergeben eine Ausrichtbarkeit der Gehäusehälften unmittelbar am bzw. innerhalb des Gewindeansatzes 4, so dass die übrigen Verbindungsmittel des Gehäuses 3 relativ grob tolerierbar sind und lediglich eine Heftfunktion vor der Montage des Eingabeaggregates 1 an der Wand 2 ausüben müssen. Mit anderen Worten, beim Befestigen des Eingabeaggregates 1 mittels des Gehäuses 3, wird das Gehäuse 3 mittelbar zusammengefügt.

Der Halterung des Eingabeaggregates 1 innerhalb des Gehäuses 3 andererseits auch der Abstützung beim Betätigen des Drehschalters 6 dienen der Leiterplatte 7 zugeordnete, in beiden Gehäusebauteilen 9, 10 wechselweise ausgebildete Rippenelemente. Die im Gehäusebauteil 10 vorgesehenen Rippenelemente sind mit 31, 32, 33 und 34 bezeichnet. Im Gehäusebauteil 9 tragen die Rippenelemente die Bezugszeichen 35, 36 und 37. Außerdem sind an dem Gehäusebauteil 9 der Halterung der Leiterplatte 7 dienende, mittels nicht näher bezeichneter Rippen Schlitze 38 und 39 ausgeformt. Mehrere, den Gewindeansatz 4 umgebende flache Sockel, von denen einer mit 40 bezeichnet ist, bilden eine dem Gehäuse 3 zugeordnete Flanschfläche.

## Patentansprüche

1. Gehäuse für ein Eingabeaggregat mit einem Drehschalter, welcher auf einer Leiterplatte angeordnet ist, mit einer dem Drehschalter zugeordneten Stellwelle und mit einem auf der Leiterplatte befestigten Steckersockel sowie mit Mitteln zum Befestigen des Eingabeaggregates an einer Wand, wobei die Stellwelle durch die Wand hindurchgreift,
**dadurch gekennzeichnet,**
**dass** das Gehäuse (3) Mittel zur Halterung des Eingabeaggregates (1) aufweist, dass an dem Gehäuse (3) ein Gewindeansatz (4) ausgebildet ist und
**dass** die Befestigung des Eingabeaggregates (1) mittelbar durch Verschrauben des Gehäuses (3) mit der Wand (2) erfolgt.

2. Gehäuse für ein Eingabeaggregat nach Anspruch 1,
**dadurch gekennzeichnet,**
**dass** das Gehäuse (3) zweiteilig derart ausgebildet ist, dass an jedem Gehäusebauteil (9, 10) eine Hälfte (19, 20) des Gewindeansatzes (4) angeformt ist.

3. Gehäuse für ein Eingabeaggregat nach Anspruch 2,
**dadurch gekennzeichnet,**
**dass** an den beiden Gehäusebauteilen (9, 10) ein werkzeugloses Zusammenfügen des Gehäuses (3) gestaltende Verbindungsmittel ausgebildet sind.

4. Gehäuse für ein Eingabeaggregat nach Anspruch 3,
**dadurch gekennzeichnet,**
**dass** an den den Gewindeansatzhälften (19, 20) abgewandten Wänden der Gehäusebauteile (9, 19) Mittel für wenigstens eine Renkverbindung, an den mit den Gewindeansatzhälften (9, 10) versehenen Wänden Mittel für wenigstens eine Rastverbindung angeformt sind.

5. Gehäuse für ein Eingabeaggregat nach Anspruch 1,
**dadurch gekennzeichnet,**
**dass** die Gewindeansatzhälften (19, 20) als der Stellwelle (5) zugeordnete Lagerschalen ausgebildet sind.

6. Gehäuse für ein Eingabeaggregat nach Anspruch 1,
**dadurch gekennzeichnet,**
**dass** an den Gehäusebauteilen (9, 10) als Fassung für die Leiterplatte (7) dienende Rippenelemente (31 bis 37) sowie Schlitze (38, 39) vorgesehen sind.
